# EUROPEAN PATENT APPLICATION

(11) **EP 4 340 037 A1**
(43) Date of publication of application: **20.03.2024**
(21) Application number: 23154449.5
(22) Date of filing: 01.02.2023
(51) Int. Cl.: H01L 29/08, H01L 29/78, H01L 29/12, H01L 21/336

(54) **SEMICONDUCTOR DEVICE AND METHOD FOR MANUFACTURING THE SAME**

(30) Priority: 14.09.2022 JP 2022146368
(71) Applicant: Kabushiki Kaisha Toshiba, Minato-ku Tokyo (JP); Toshiba Electronic Devices & Storage Corporation, Tokyo (JP)
(72) Inventor: ASABA, Shunsuke, Hyogo (JP); KONO, Hiroshi, Hyogo (JP)
(74) Representative: Kramer Barske Schmidtchen Patentanwälte PartG mbB

(57) **Abstract**

A semiconductor device includes a first electrode, a first semiconductor layer connected to the first electrode, a second semiconductor layer located on a portion of the first semiconductor layer, a third semiconductor layer located on a portion of the second semiconductor layer, a second electrode connected to the third semiconductor layer, and a third electrode located in a region directly above at least a portion of the second semiconductor layer between the first semiconductor layer and the third semiconductor layer. The third semiconductor layer faces the first semiconductor layer via the second semiconductor layer. A side surface of the third semiconductor layer facing the first semiconductor layer has a shape that approaches the first semiconductor layer upward. The third semiconductor layer is of a first conductivity type and includes silicon and carbon. The third electrode faces the portion via a first insulating film.

## Description

### FIELD

Embodiments relate to a semiconductor device and a method for manufacturing the same.

### BACKGROUND

Semiconductor devices that use silicon carbide as a semiconductor material are being developed to improve the balance between the on-resistance and the breakdown voltage of the semiconductor device. In such a semiconductor device as well, it is favorable to reduce the channel length to further reduce the on-resistance, but there are cases where reducing the channel length lowers the threshold voltage and makes operations unstable.

### BRIEF DESCRIPTION OF THE DRAWINGS

FIG. 1 is a plan view showing a semiconductor device according to a first embodiment;
FIG. 2 is a cross-sectional view along line A-A' shown in FIG. 1;
FIG. 3 is a partially enlarged cross-sectional view showing region B of FIG. 2;
FIGS. 4A to 5C are process cross-sectional views showing a method for manufacturing the semiconductor device according to the first embodiment;
FIGS. 6A and 6B are process cross-sectional views showing a method for manufacturing a semiconductor device according to a second embodiment;
FIGS. 7A and 7B are process cross-sectional views showing a method for manufacturing a semiconductor device according to a comparative example;
FIG. 8 is a partially enlarged cross-sectional view showing the semiconductor device according to the comparative example;
FIG. 9A shows a test method of a first test example; and FIGS. 9B to 9D show results of the first test example; and
FIGS. 10A and 10B show results of a second test example.

### DETAILED DESCRIPTION

In general, according to one embodiment, a_semiconductor device includes a first electrode, a first semiconductor layer connected to the first electrode, a second semiconductor layer located on a portion of the first semiconductor layer, a third semiconductor layer located on a portion of the second semiconductor layer, a second electrode connected to the third semiconductor layer, and a third electrode located in a region directly above at least a portion of the second semiconductor layer between the first semiconductor layer and the third semiconductor layer. The first semiconductor layer is of a first conductivity type and includes silicon and carbon. The second semiconductor layer is of a second conductivity type and includes silicon and carbon. The third semiconductor layer faces the first semiconductor layer via the second semiconductor layer. A side surface of the third semiconductor layer facing the first semiconductor layer has a shape that approaches the first semiconductor layer upward. The third semiconductor layer is of a first conductivity type and includes silicon and carbon. The third electrode faces the portion via a first insulating film.

In general, according to one embodiment, a method for manufacturing a semiconductor device includes forming a mask member on a first semiconductor layer of a first conductivity type. The first semiconductor layer includes silicon and carbon. The method includes forming a second semiconductor layer in a portion of an upper portion of the first semiconductor layer by implanting a first impurity into the first semiconductor layer by using the mask member as a mask. The second semiconductor layer is of a second conductivity type. The method includes forming a spacer film on the first semiconductor layer and on the second semiconductor layer. The spacer film covers the mask member. The method includes forming a third semiconductor layer in a portion of an upper portion of the second semiconductor layer by implanting a second impurity into the second semiconductor layer via the spacer film by using the mask member as a mask. The third semiconductor layer is of the first conductivity type. The method includes removing the spacer film and the mask member. The method includes forming a first insulating film on at least a portion of the second semiconductor layer between the first semiconductor layer and the third semiconductor layer. The method includes forming a first electrode connected to the first semiconductor layer, a second electrode connected to the third semiconductor layer, and a third electrode located on the first insulating film.

### First embodiment

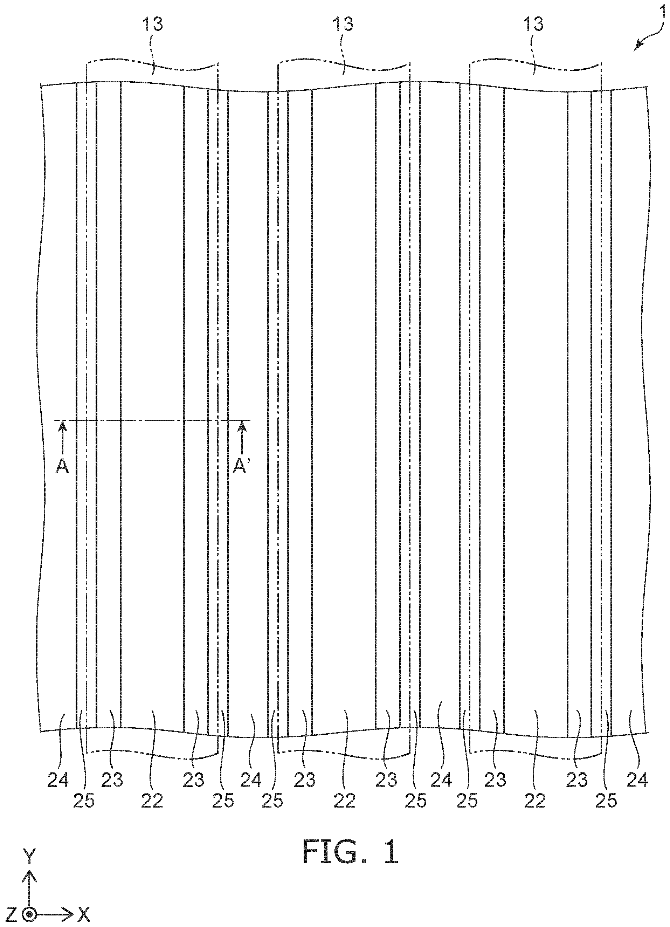

FIG. 1 is a plan view showing a semiconductor device according to the embodiment.

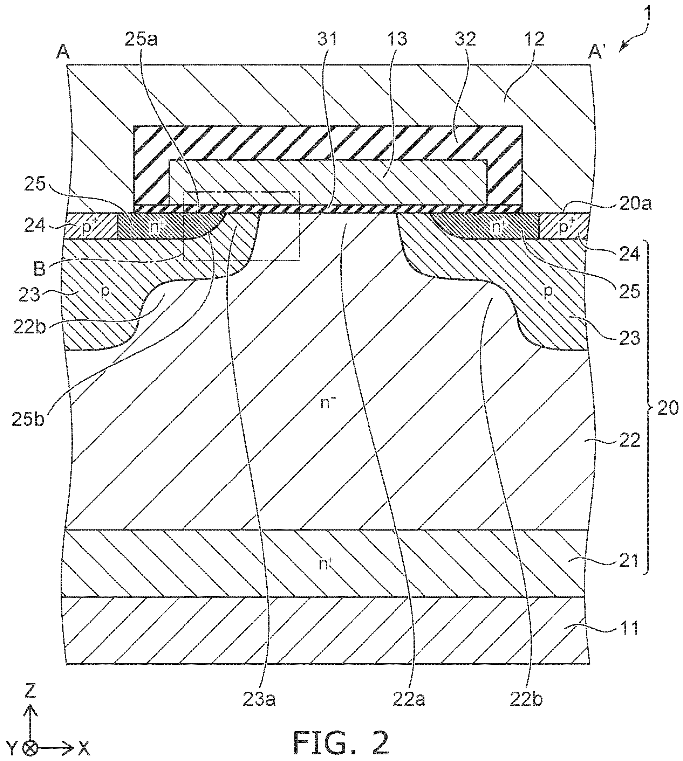

FIG. 2 is a cross-sectional view along line A-A' shown in FIG. 1.

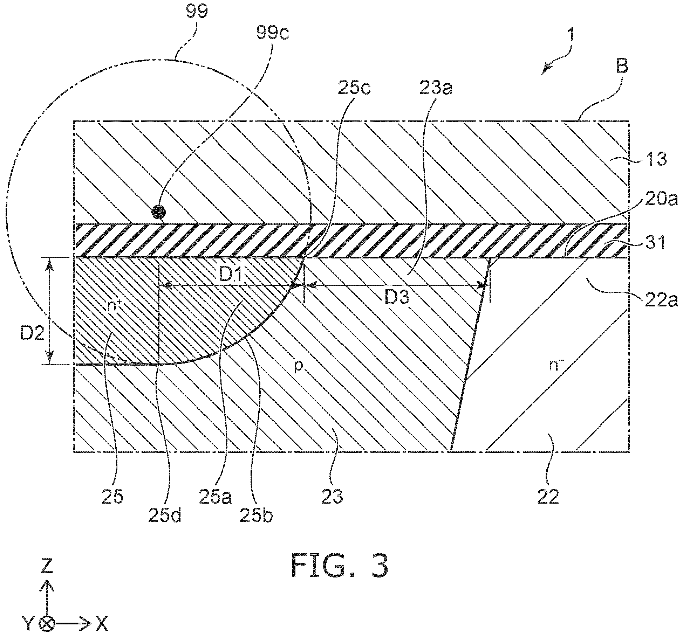

FIG. 3 is a partially enlarged cross-sectional view showing region B of FIG. 2.

The drawings are schematic, and are simplified and enhanced as appropriate. The shapes and dimensional ratios of the components do not necessarily match exactly between the drawings. This is similar for the other drawings described below as well.

As shown in FIGS. 1 and 2, the semiconductor device 1 according to the embodiment includes a drain electrode 11, a semiconductor part 20, a source electrode 12, a gate electrode 13, a gate insulating film 31, and an inter-electrode insulating film 32. The semiconductor part 20 is located between the drain electrode 11 and the source electrode 12. The drain electrode 11 is provided over the entire or substantially the entire lower surface of the semiconductor part 20. The source electrode 12 is provided over substantially the entire upper surface of the semiconductor part 20 other than a gate pad (not illustrated). In FIG. 1, the source electrode 12, the gate insulating film 31, and the inter-electrode insulating film 32 are not illustrated, and the gate electrode 13 is shown by a double dot-dash line. The semiconductor device 1 is a vertical MOSFET (Metal-Oxide-Semiconductor Field-Effect Transistor).

In the specification, an XYZ orthogonal coordinate system is employed for convenience of description. The arrangement direction of the drain electrode 11 and the source electrode 12 is taken as a "Z-direction"; the direction of the channel length of the MOSFET included in the semiconductor device 1 is taken as an "X-direction"; and the direction of the channel width is taken as a "Y-direction". Among the Z-directions, a direction that is from the drain electrode 11 toward the source electrode 12 also is called "up", and the opposite direction also is called "down", but these expressions are for convenience and are independent of the direction of gravity.

The semiconductor part 20 is made of single-crystal silicon carbide (SiC); and the conductivity types of the portions are set by locally including impurities. The semiconductor part 20 includes an n⁺-type drain layer 21, an n-type drift layer 22, a p-type base layer 23, a p⁺-type contact layer 24, and an n⁺-type source layer 25. The "n⁺-type" refers to a higher carrier concentration than the "n⁻-type"; and the "p-type" refers to a higher carrier concentration than the "p⁻-type". The "carrier concentration" refers to the effective impurity concentration functioning as a donor or acceptor.

The drain layer 21 contacts the drain electrode 11 and is connected to the drain electrode 11. In the specification, "connected" means an electrical connection. The drift layer 22 is located on the drain layer 21 and contacts the drain layer 21. The base layer 23 is located on a portion of the drift layer 22 and contacts the drift layer 22. The upper surface of a remaining portion 22a of the drift layer 22, i.e., the portion 22a on which the base layer 23 is not located, forms a portion of an upper surface 20a of the semiconductor part 20.

The contact layer 24 is located on a portion of the base layer 23 and contacts the base layer 23. The source layer 25 is located on another portion of the base layer 23 and contacts the base layer 23. The contact layer 24 and the source layer 25 may contact each other. The contact layer 24 and the source layer 25 are separated from the drift layer 22 with the base layer 23 interposed. The source layer 25 faces the drift layer 22 via the base layer 23 at the upper surface 20a of the semiconductor part 20. The upper surface of a remaining portion 23a of the base layer 23, i.e., the portion on which neither the contact layer 24 or the source layer 25 is located, forms a portion of the upper surface 20a of the semiconductor part 20.

In the semiconductor device 1, for example, the multiple base layers 23 are located on the drift layer 22 and separated from each other along the X-direction. Each base layer 23 extends in the Y-direction. The contact layer 24 and the source layer 25 are located on each base layer 23. For example, one contact layer 24 and two source layers 25 between which the contact layer 24 is interposed are located at each base layer 23. The contact layer 24 and the source layer 25 extend in the Y-direction. However, the positional relationship of the contact layer 24 and the source layer 25 in the XY plane is not limited to the example.

The gate insulating film 31 is located on the upper surface 20a of the semiconductor part 20. For example, the gate insulating film 31 is made of silicon oxide (SiO). The gate insulating film 31 contacts the upper surface of the portion 22a of the drift layer 22, the upper surface of the portion 23a of the base layer 23, and the upper surface of a portion 25a of the source layer 25 at the portion 23a side of the base layer 23.

The gate electrode 13 is located on the gate insulating film 31 and contacts the gate insulating film 31. The gate electrode 13 is located in the region directly above at least the portion 23a of the base layer 23 between the drift layer 22 and the source layer 25 and faces the portion 23a via the gate insulating film 31. For example, the gate electrode 13 is provided over the region directly above the portion 22a of the drift layer 22 positioned between two adjacent base layers 23, the regions directly above the portions 23a of these two base layers 23 between the respective portions 22a and source layers 25, and the regions directly above the portions 25a of the source layers 25 at the portion 23a sides of the base layers 23; and the gate electrode 13 faces these portions via the gate insulating film 31. The gate electrode 13 extends in the Y-direction and is connected to a gate pad (not illustrated).

The inter-electrode insulating film 32 is provided on a portion of the semiconductor part 20 and over the entire gate insulating film 31, and covers the gate electrode 13. For example, the inter-electrode insulating film 32 is made of silicon oxide. The source electrode 12 is located on the semiconductor part 20 and covers the inter-electrode insulating film 32. Accordingly, the source electrode 12 covers the gate electrode 13 via the inter-electrode insulating film 32. Thereby, the source electrode 12 is insulated from the gate electrode 13 by the inter-electrode insulating film 32. The source electrode 12 is connected to the contact layer 24 and the source layer 25 at the upper surface 20a of the semiconductor part 20.

As shown in FIG. 3, a side surface 25b of the source layer 25 at the X-direction side faces the portion 22a of the drift layer 22 via the portion 23a of the base layer 23. The shape of the side surface 25b in the XZ cross section is a shape along a virtual circular arc 99. A center 99c of the circular arc 99 is positioned above the source layer 25, e.g., inside the gate electrode 13. Therefore, the side surface 25b has a shape that approaches the portion 22a of the drift layer 22 upward. In other words, in the XZ cross section, an upper edge 25c of the side surface 25b is the portion of the side surface 25b most proximate to the portion 22a; and a lower edge 25d of the side surface 25b is the portion of the side surface 25b most distant to the portion 22a.

It is favorable for a distance D1 in the X-direction between the upper edge 25c and the lower edge 25d when viewed from above, i.e., the Z-direction, to be greater than a distance D2 in the Z-direction between the upper edge 25c and the lower edge 25d when viewed laterally, i.e., the Y-direction. In other words, it is favorable for *D1* > *D2.* The distance D2 is the thickness of the source layer 25. A distance D3 shown in FIG. 3 is the channel length of the MOSFET.

A method for manufacturing the semiconductor device according to the embodiment will now be described.

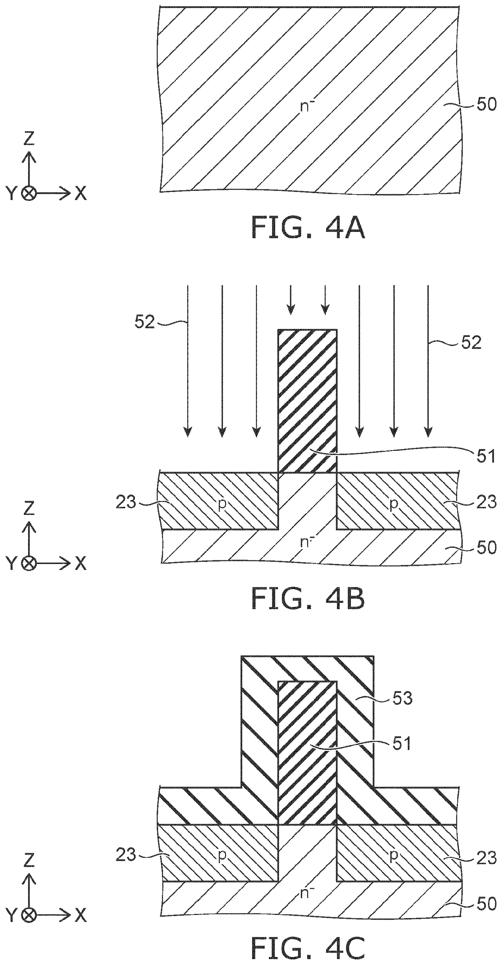

FIGS. 4A to 5C are process cross-sectional views showing the method for manufacturing the semiconductor device according to the embodiment.

First, a semiconductor substrate 50 is prepared as shown in FIG. 4A. For example, the semiconductor substrate 50 is formed by epitaxially growing an n⁻-type silicon carbide layer on an n⁺-type silicon carbide wafer. In the semiconductor device 1 after completion, the semiconductor substrate 50 becomes the semiconductor part 20; the silicon carbide wafer becomes the drain layer 21; and the epitaxially-grown silicon carbide layer becomes the drift layer 22. The base layer 23, the contact layer 24, and the source layer 25 are not formed at the stage shown in FIG. 4A.

Then, as shown in FIG. 4B, a mask member 51 is formed on the semiconductor substrate 50. For example, the mask member 51 is formed of silicon oxide. Then, an impurity 52 that forms acceptors is ion-implanted into the upper layer portion of the semiconductor substrate 50, i.e., the portion corresponding to the drift layer 22, by using the mask member 51 as a mask. Thereby, the p-type base layer 23 is formed in a portion of the upper portion of the drift layer 22.

Continuing as shown in FIG. 4C, a spacer film 53 that covers the mask member 51 is formed on the semiconductor substrate 50. For example, the spacer film 53 is formed of silicon oxide, silicon nitride (SiN), or silicon (Si).

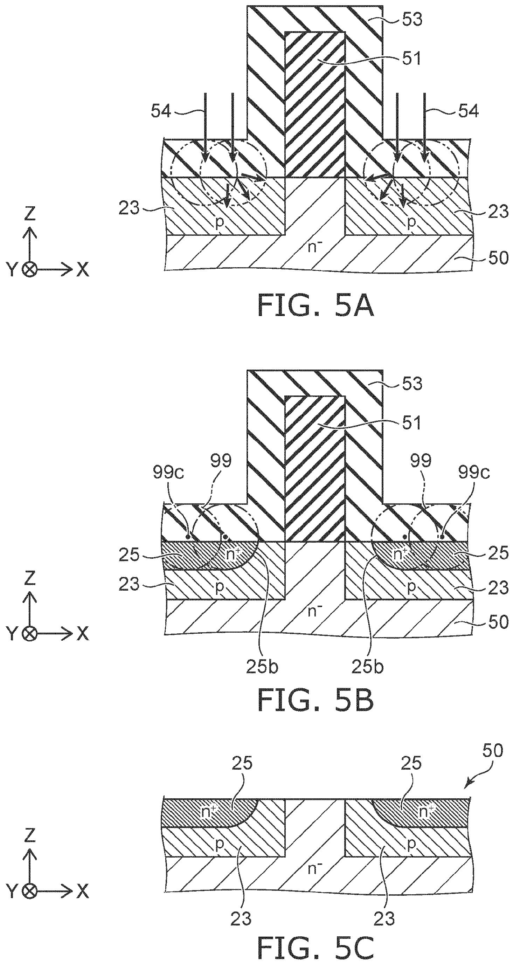

Then, as shown in FIG. 5A, an impurity 54 that forms donors is ion-implanted into the base layer 23 via the spacer film 53 by using the mask member 51 as a mask. At this time, the acceleration voltage of the ion implantation of the impurity 54 is set to a voltage that causes the impurity 54 ion-implanted from above to scatter inside the spacer film 53 and reach the upper portion of the base layer 23.

Thereby, as shown in FIG. 5B, the n⁺-type source layer 25 is formed in a portion of the upper portion of the base layer 23. The distribution of the ion-implanted impurity 54 spreads in a spherical shape having the center 99c positioned inside the spacer film 53 as the center. Therefore, the shape of the portion of the semiconductor substrate 50 in which the impurity 54 is distributed, i.e., the shape of the source layer 25, is a shape formed by many spheres being continuously distributed along the XY plane. Accordingly, the shape of the source layer 25 has a substantially flat plate shape that spreads along the XY plane and has a constant Z-direction thickness. The upper surface of the source layer 25 contacts the spacer film 53; the side surface 25b of the source layer 25 has a shape along a portion of a circular pillar shape; and the shape of the side surface 25b in a cross section parallel to the Z-direction is a shape along the virtual circular arc 99 having the center 99c as the center.

Then, the spacer film 53 and the mask member 51 are removed as shown in FIG. 5C. The upper surface of the semiconductor substrate 50 is exposed thereby.

Continuing as shown in FIG. 2, a mask member (not illustrated) is formed; and an impurity that forms acceptors is ion-implanted using the mask member as a mask. Thereby, the p⁺-type contact layer 24 is formed in at least a portion of the upper portion of the base layer 23 at which the source layer 25 is not formed. Then, the mask member is removed. Then, the impurities that are implanted into the semiconductor substrate 50 are activated by activation heat treatment. Then, thermal oxidation treatment of the semiconductor substrate 50 is performed. Thereby, the gate insulating film 31 is formed over the entire upper surface of the semiconductor substrate 50. The gate insulating film 31 is formed on at least the portion 23a of the base layer 23 between the drift layer 22 and the source layer 25.

Then, the gate electrode 13 is formed on the gate insulating film 31. Then, the gate insulating film 31 is etched using the gate electrode 13 as a mask, so that the gate insulating film 31 remains in the region directly under the gate electrode 13 and is removed from the region other than the region directly under the gate electrode 13. Then, the inter-electrode insulating film 32 is formed on the semiconductor substrate 50 and on the gate electrode 13. Then, the inter-electrode insulating film 32 is selectively removed. Thereby, the contact layer 24 and a portion of the source layer 25 are exposed from under the inter-electrode insulating film 32 while the gate electrode 13 is covered with the inter-electrode insulating film 32.

Continuing, the source electrode 12 is formed on the semiconductor substrate 50 and on the inter-electrode insulating film 32. The source electrode 12 is insulated from the gate electrode 13 by the inter-electrode insulating film 32 and contacts the source layer 25 and the contact layer 24. The drain electrode 11 is formed on the lower surface of the semiconductor substrate 50. The drain electrode 11 contacts the lower surface of the semiconductor substrate 50. Then, the structure body that includes the drain electrode 11, the semiconductor substrate 50, the gate insulating film 31, the gate electrode 13, the inter-electrode insulating film 32, and the source electrode 12 is singulated by dicing. The multiple semiconductor devices 1 are manufactured thereby.

Effects of the embodiment will now be described.

In the semiconductor device 1 according to the embodiment as shown in FIG. 3, the side surface 25b of the source layer 25 has a shape that approaches the portion 22a of the drift layer 22 upward. Therefore, the source layer 25 is not interposed between the portion 23a of the base layer 23 in which the inversion layer is formed and a portion 22b of the drift layer 22 (see FIG. 2) positioned in the region directly under the portion 23a. Therefore, the potential of the drain electrode 11 is easily conducted to the portion 23a; and the inversion layer is not formed easily. As a result, the threshold voltage of the MOSFET is high. Thereby, while reducing the on-resistance by reducing the distance D3, i.e., the channel length, a prescribed threshold voltage can be ensured, and the operations of the semiconductor device 1 can be stabilized. For example, the unintended formation of, and conduction by, an inversion layer due to noise or the like when the MOSFET is in the off-state can be suppressed.

The effects described above can be more reliably obtained by setting the distance D1 in the X-direction between the upper edge 25c and the lower edge 25d of the side surface 25b of the source layer 25 to be greater than the distance D2 in the Z-direction, i.e., the thickness of the source layer 25. The threshold voltage of the semiconductor device 1 can be ensured thereby, and the operations can be further stabilized.

### Second embodiment

The embodiment is another method for manufacturing the semiconductor device according to the first embodiment.

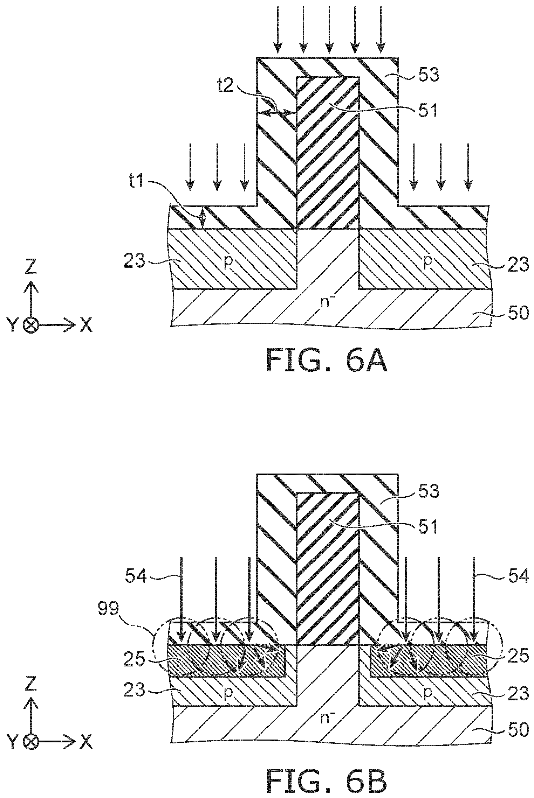

FIGS. 6A and 6B are process cross-sectional views showing the method for manufacturing the semiconductor device according to the embodiment.

First, the processes shown in FIGS. 4A to 4C are performed.

Then, as shown in FIG. 6A, anisotropic etching such as RIE (Reactive Ion Etching) or the like of the spacer film 53 is performed. The spacer film 53 that is on the upper surface of the semiconductor substrate 50 is not completely removed at this time. The spacer film 53 that is on the upper surface of the semiconductor substrate 50 and on the upper surface of the mask member 51 is thinned thereby. On the other hand, the spacer film 53 that is on the side surface of the mask member 51 is not thinned very much.

Thereby, a thickness t1 in the Z-direction of the spacer film 53 on the upper surface of the semiconductor substrate 50 and a thickness t2 in the X-direction of the spacer film 53 on the side surface of the mask member 51 can be controlled independently from each other. According to the embodiment, the thickness t1 is less than the thickness t2. In other words, *t1* < *t2.*

Then, as shown in FIG. 6B, the impurity 54 that forms donors is ion-implanted into the base layer 23 via the spacer film 53 by using the mask member 51 as a mask. Thereby, the n⁺-type source layer 25 is formed in a portion of the upper portion of the base layer 23. The acceleration voltage of the ion implantation of the impurity 54 is a voltage that causes the impurity 54 ion-implanted from above to scatter inside the spacer film 53 and reach the upper portion of the base layer 23. Then, the process shown in FIG. 5C is performed. The subsequent processes are similar to those of the first embodiment.

Effects of the embodiment will now be described.

As shown in FIGS. 6A and 6B, compared with the first embodiment, the acceleration voltage of the impurity 54 for forming the source layer 25 of the prescribed thickness according to the embodiment can be low because the thickness t1 in the Z-direction of the spacer film 53 is thin. The spreading of the impurity 54 along the XY plane can be suppressed thereby. As a result, the shape of the source layer 25 can be controlled with high accuracy.

Thus, according to the embodiment, the shape of the source layer 25 and the like can be controlled by adjusting the thickness t1 in the Z-direction of the spacer film 53. On the other hand, the channel length (the distance D3) can be controlled by adjusting the thickness t2 in the X-direction of the spacer film 53. The thickness t2 of the spacer film 53 can be adjusted by controlling the deposition amount of the spacer film 53 in the process shown in FIG. 4C. Thus, according to the embodiment, the shape and the like of the source layer 25 and the channel length (the distance D3) can be controlled independently from each other. Otherwise, the configuration, the manufacturing method, and the effects of the embodiment are similar to those of the first embodiment.

### Comparative example

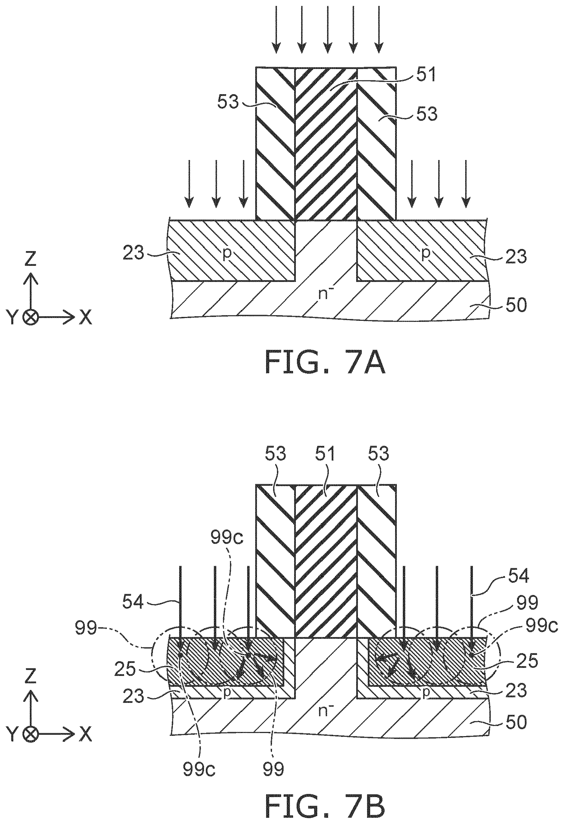

FIGS. 7A and 7B are process cross-sectional views showing a method for manufacturing a semiconductor device according to the comparative example.

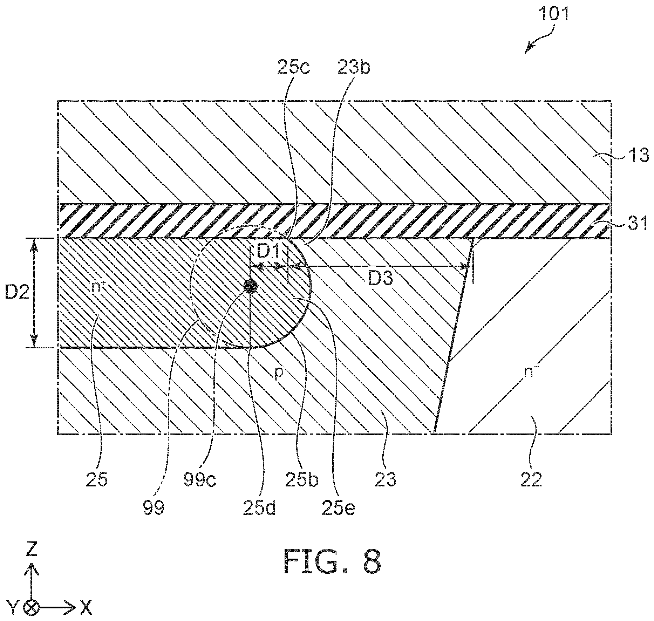

FIG. 8 is a partially enlarged cross-sectional view showing the semiconductor device according to the comparative example.

FIG. 8 shows a region corresponding to FIG. 3.

First, the processes shown in FIGS. 4A to 4C are performed.

Then, as shown in FIG. 7A, the spacer film 53 that is on the upper surface of the semiconductor substrate 50 is removed by performing anisotropic etching of the spacer film 53. At this time, the spacer film 53 remains on the side surface of the mask member 51. In other words, the thickness t1 shown in FIG. 6A is set to a value of 0, and the thickness t2 is set to a value greater than 0.

Then, as shown in FIG. 7B, the impurity 54 that forms donors is ion-implanted into the base layer 23 by using the mask member 51 and the spacer film 53 as a mask. At this time, the impurity 54 is directly implanted into the semiconductor substrate 50 without passing through the spacer film 53. Thereby, the impurity 54 spreads in a spherical shape having the center 99c positioned inside the semiconductor substrate 50 as the center. The source layer 25 is formed thereby.

In the semiconductor device 101 according to the comparative example as shown in FIG. 8, because the center 99c of the virtual circular arc 99 is positioned inside the source layer 25, a portion 25e of the source layer 25 is interposed between a portion 23b of the upper layer portion of the base layer 23 at the source layer 25 side and the portion 22b of the drift layer 22 (see FIG. 2) located in the region directly under the portion 23b. Thereby, the potential of the drain electrode is not easily conducted to the portion 23b; and the inversion layer is easily formed. As a result, the threshold voltage of the MOSFET is lowered. Therefore, for the same channel length (distance D3), the threshold voltage of the semiconductor device 101 is less than that of the semiconductor device 1 according to the first embodiment. The operations may become unstable as the threshold voltage decreases.

While the channel length (the distance D3) could be increased to ensure a sufficient threshold voltage in the semiconductor device 101, doing so would increase the on-resistance. It also may be considered to form a source layer having a shape similar to that of the source layer 25 shown in FIG. 3 by forming a semiconductor substrate of silicon (Si) instead of silicon carbide (SiC) and by thermally diffusing an impurity implanted shallowly into the upper surface vicinity of the semiconductor substrate. However, in such a case, the balance between the on-resistance and the breakdown voltage is degraded because the bandgap of silicon is narrower than the bandgap of silicon carbide.

### First test example

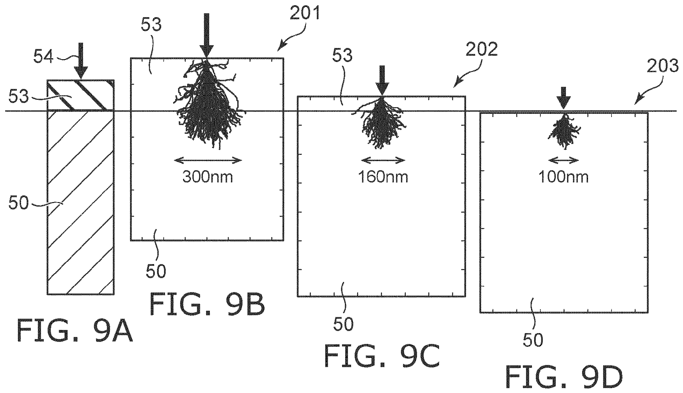

FIG. 9A shows a test method of a test example; and FIGS. 9B to 9D show results of the test example.

FIGS. 9B to 9D show traces of simulation results.

As shown in FIG. 9A, the test example assumed three types of samples in which the spacer film 53 made of polysilicon was formed on the semiconductor substrate 50 made of silicon carbide. The thickness of the spacer film 53 was different between the samples. The behavior of nitrogen as an impurity for these samples was then simulated by simulating the ion implantation of nitrogen into the semiconductor substrate 50. The acceleration voltage of the ion implantation was adjusted for each sample so that the nitrogen concentration and depth reached in the semiconductor substrate 50 respectively were substantially equal between the samples.

In a sample 201 as shown in FIG. 9B, the thickness of the spacer film 53 was set to 200 nm. As a result, the nitrogen scattered mainly inside the spacer film 53; the portion inside the semiconductor substrate 50 in which the nitrogen was distributed had a shape similar to a lower portion of a sphere having the center positioned inside the spacer film 53; and the spreading width was about 300 nm.

In a sample 202 as shown in FIG. 9C, the thickness of the spacer film 53 was set to 50 nm. As a result, the nitrogen scattered inside the spacer film 53 and inside the semiconductor substrate 50; the portion inside the semiconductor substrate 50 in which the nitrogen was distributed had a spherical shape having the center positioned inside the semiconductor substrate 50; and the spreading width was about 160 nm.

In a sample 203 as shown in FIG. 9D, the thickness of the spacer film 53 was set to 0 nm. In other words, the spacer film 53 was not provided. As a result, the nitrogen was scattered inside the semiconductor substrate 50; the portion inside the semiconductor substrate 50 in which the nitrogen was distributed had a shape similar to a sphere having the center positioned inside the semiconductor substrate 50; and the spreading width was about 100 nm.

### Second test example

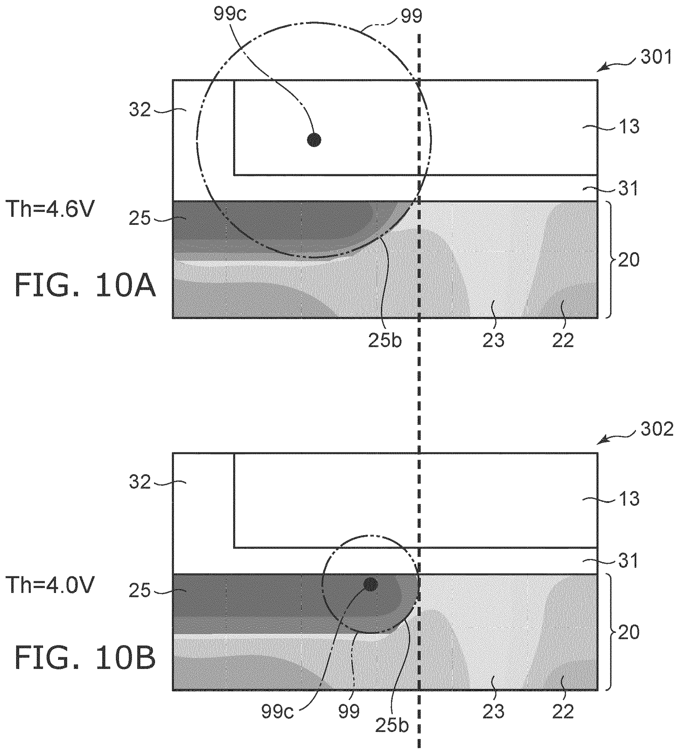

FIGS. 10A and 10B show results of a test example.

In the test example, the methods for manufacturing the semiconductor devices according to the comparative example and the first embodiment described above were simulated, and the threshold voltages of each were calculated. In FIGS. 10A and 10B, darker colors indicate higher donor concentrations. FIGS. 10A and 10B show traces of simulation results of the concentration distribution of the impurity. Not all of the simulation results can be illustrated due to tracing constraints. However, the interface between the base layer 23 and the source layer 25 could be discriminated based on the original simulation results; and the interface is shown in FIGS. 10A and 10B.

A sample 301 shown in FIG. 10A is a test example of the first embodiment. In the sample 301, the spacer film 53 was deposited to a thickness of 200 nm, and etch-back of the spacer film 53 was not performed. Therefore, the thickness t1 of the spacer film 53 was 200 nm. Then, the acceleration voltage was selected to form the source layer 25 with the prescribed thickness and impurity concentration; and the impurity 54 was ion-implanted. As a result, as shown in FIG. 10A, the shape of the side surface 25b of the source layer 25 of the sample 301 was a shape along the circular arc 99 having the center 99c positioned higher than the semiconductor part 20. A threshold voltage Th of the sample 301 was 4.6 V.

A sample 302 shown in FIG. 10B is a test example of a comparative example. In the sample 302, the spacer film 53 was deposited to a thickness of 80 nm, and etch-back of 80 nm of the spacer film 53 was performed. In other words, the thickness t1 was set to 0 nm without the spacer film 53 remaining. Then, an acceleration voltage was selected to form the source layer 25 with the prescribed thickness and impurity concentration; and the impurity 54 was ion-implanted. As a result, in the sample 302 as shown in FIG. 10B, the shape of the side surface 25b of the source layer 25 was a shape along the circular arc 99 having the center 99c positioned inside the semiconductor part 20. The threshold voltage Th of the sample 302 was 4.0 V.

Thus, the threshold voltage Th (4.6 V) of the sample 301 according to the first embodiment was greater than the threshold voltage Th (4.0 V) of the sample 302 according to the comparative example.

According to the embodiments described above, a semiconductor device and a method for manufacturing a semiconductor device can be realized in which a lowering of the threshold voltage can be suppressed even when the channel length is reduced.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

Embodiments include the following aspects.

### Note 1

A semiconductor device, comprising:
a first electrode;
a first semiconductor layer connected to the first electrode, the first semiconductor layer being of a first conductivity type and including silicon and carbon;
a second semiconductor layer located on a portion of the first semiconductor layer, the second semiconductor layer being of a second conductivity type and including silicon and carbon;
a third semiconductor layer located on a portion of the second semiconductor layer, the third semiconductor layer facing the first semiconductor layer via the second semiconductor layer, a side surface of the third semiconductor layer facing the first semiconductor layer and having a shape that approaches the first semiconductor layer upward, the third semiconductor layer being of a first conductivity type and including silicon and carbon;
a second electrode connected to the third semiconductor layer; and
a third electrode located in a region directly above at least a portion of the second semiconductor layer between the first semiconductor layer and the third semiconductor layer, the third electrode facing the portion via a first insulating film.

### Note 2

The device according to note 1, wherein
a cross-sectional shape of the side surface of the third semiconductor layer is a shape along a virtual circular arc having a center positioned above the third semiconductor layer.

### Note 3

The device according to note 1 or 2, wherein
a distance between an upper edge and a lower edge of the side surface when viewed from above is greater than a thickness of the third semiconductor layer when viewed laterally.

### Note 4

The device according to any one of notes 1-3, wherein
the third electrode is located, with the first insulating film interposed, on a portion of the first semiconductor layer where the second semiconductor layer is not located and on a portion of the third semiconductor layer at the second semiconductor layer side.

### Note 5

The device according to any one of notes 1-4, wherein
the second electrode contacts the third semiconductor layer, and
the second electrode covers the third electrode via a second insulating film.

### Note 6

The device according to any one of notes 1-5, wherein
the first semiconductor layer is located on the first electrode and contacts the first electrode.

### Note 7

A method for manufacturing a semiconductor device, the method comprising:
forming a mask member on a first semiconductor layer of a first conductivity type, the first semiconductor layer including silicon and carbon;
forming a second semiconductor layer in a portion of an upper portion of the first semiconductor layer by implanting a first impurity into the first semiconductor layer by using the mask member as a mask, the second semiconductor layer being of a second conductivity type;
forming a spacer film on the first semiconductor layer and on the second semiconductor layer, the spacer film covering the mask member;
forming a third semiconductor layer in a portion of an upper portion of the second semiconductor layer by implanting a second impurity into the second semiconductor layer via the spacer film by using the mask member as a mask, the third semiconductor layer being of the first conductivity type;
removing the spacer film and the mask member;
forming a first insulating film on at least a portion of the second semiconductor layer between the first semiconductor layer and the third semiconductor layer; and
forming
   a first electrode connected to the first semiconductor layer,
   a second electrode connected to the third semiconductor layer, and
   a third electrode located on the first insulating film.

### Note 8

The method for manufacturing the device according to note 7, further comprising:
thinning the spacer film after the forming of the spacer film and before the forming of the third semiconductor layer,
the spacer film remaining on the second semiconductor layer in the forming of the third semiconductor layer.

### Note 9

The method for manufacturing the device according to note 7 or 8, wherein
the second impurity scatters inside the spacer film and reaches the upper portion of the second semiconductor layer in the forming of the third semiconductor layer.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A semiconductor device, comprising:
a first electrode (11);
a first semiconductor layer (21+22) connected to the first electrode, the first semiconductor layer being of a first conductivity type (n) and including silicon and carbon;
a second semiconductor layer (23) located on a portion of the first semiconductor layer, the second semiconductor layer being of a second conductivity type (p) and including silicon and carbon;
a third semiconductor layer (25) located on a portion of the second semiconductor layer, the third semiconductor layer facing the first semiconductor layer via the second semiconductor layer, a side surface (25b) of the third semiconductor layer facing the first semiconductor layer and having a shape that approaches the first semiconductor layer upward, the third semiconductor layer being of a first conductivity type and including silicon and carbon;
a second electrode (12) connected to the third semiconductor layer; and
a third electrode (13) located in a region directly above at least a portion (23a) of the second semiconductor layer between the first semiconductor layer and the third semiconductor layer, the third electrode facing the portion (23a) via a first insulating film (31).

2. The device according to claim 1, wherein
a cross-sectional shape of the side surface (25b) of the third semiconductor layer is a shape along a virtual circular arc (99) having a center (99c) positioned above the third semiconductor layer.

3. The device according to claim 1 or 2, wherein
a distance (D1) between an upper edge (25c) and a lower edge (25d) of the side surface (25b) when viewed from above is greater than a thickness (D2) of the third semiconductor layer when viewed laterally.

4. The device according to any one of claims 1-3, wherein
the third electrode (13) is located, with the first insulating film interposed, on a portion (22a) of the first semiconductor layer where the second semiconductor layer is not located and on a portion (25a) of the third semiconductor layer at the second semiconductor layer side.

5. The device according to any one of claims 1-4, wherein
the second electrode contacts the third semiconductor layer, and
the second electrode covers the third electrode via a second insulating film (32).

6. The device according to any one of claims 1-5, wherein
the first semiconductor layer is located on the first electrode and contacts the first electrode.

7. A method for manufacturing a semiconductor device, the method comprising:
forming a mask member (51) on a first semiconductor layer (21+22) of a first conductivity type (n), the first semiconductor layer including silicon and carbon;
forming a second semiconductor layer (23) in a portion of an upper portion of the first semiconductor layer by implanting a first impurity (52) into the first semiconductor layer by using the mask member as a mask, the second semiconductor layer being of a second conductivity type (p);
forming a spacer film (53) on the first semiconductor layer and on the second semiconductor layer, the spacer film covering the mask member;
forming a third semiconductor layer (25) in a portion of an upper portion of the second semiconductor layer by implanting a second impurity (54) into the second semiconductor layer via the spacer film by using the mask member as a mask, the third semiconductor layer being of the first conductivity type;
removing the spacer film and the mask member;
forming a first insulating film (31) on at least a portion of the second semiconductor layer between the first semiconductor layer and the third semiconductor layer; and
forming
a first electrode (11) connected to the first semiconductor layer,
a second electrode (12) connected to the third semiconductor layer, and
a third electrode (13) located on the first insulating film.

8. The method for manufacturing the device according to claim 7, further comprising:
thinning the spacer film after the forming of the spacer film and before the forming of the third semiconductor layer,
the spacer film remaining on the second semiconductor layer in the forming of the third semiconductor layer.

9. The method for manufacturing the device according to claim 7 or 8, wherein
the second impurity scatters inside the spacer film and reaches the upper portion of the second semiconductor layer in the forming of the third semiconductor layer.
